# FASCICULE DE BREVET EUROPEEN

(11) **EP 2 110 007 B1**
(45) Date de publication et mention de la délivrance du brevet: **02.11.2011**
(21) Numéro de dépôt: 08762026.6
(22) Date de dépôt: 01.02.2008
(51) Int. Cl.: H05H 1/24

(54) **DISPOSITIF POUR GÉNÉRER UN PLASMA FROID DANS UNE ENCEINTE SOUS VIDE ET UTILISATION DU DISPOSITIF POUR DES TRAITEMENTS THERMOCHIMIQUES**
VORRICHTUNG ZUR ERZEUGUNG VON KALTEM PLASMA IN EINER VAKUUMKAMMER UND VERWENDUNG DIESER VORRICHTUNG ZUR THERMOCHEMISCHEN VERARBEITUNG
DEVICE FOR GENERATING COLD PLASMA IN A VACUUM CHAMBER AND USE OF SAID DEVICE FOR THERMO-CHEMICAL PROCESSING

(30) Priorité: 15.02.2007 FR 0753289
(43) Date de publication de la demande: 21.10.2009
(73) Titulaire: H.E.F., 42160 Andrezieux-Boutheon (FR)
(72) Inventeur: MAURIN-PERRIER, Philippe, F-42680 SAINT MARCELLIN EN FOREZ (FR); CHAVANNE, Hervé, F-42170 SAINT JUST SAINT RAMBERT (FR); POIGT, Laure, F-42350 LA TALAUDIERE (FR)
(74) Mandataire: Thivillier, Patrick
(86) Numéro de dépôt international: PCT/FR2008/050166
(87) Numéro de publication internationale: WO 2008/104669

(56) Documents cités:
- EP-A2- 0 881 865
- US-A- 5 113 790
- US-A- 6 066 826

## Description

L'invention concerne un dispositif pour générer un plasma froid dans une enceinte sous pression réduite, et concerne plus particulièrement une cathode apte à générer ce plasma froid de forte puissance.

Il est parfaitement connu pour un homme du métier d'utiliser, dans l'industrie, des plasmas froids pour modifier la surface de différents types de matériaux, afin de créer des espèces actives, hors équilibre, qui n'existent pas à l'état naturel. L'utilisati3.1014on de plasmas dans les traitements thermochimiques, permet un contrôle précis de la concentration en espèces actives en opposition aux procédés conventionnels. Les plasmas froids basse pression permettent en outre de limiter, de manière significative, les consommations de gaz, ce qui présente des avantages, tant sur le plan économique qu'écologique.

Différentes solutions techniques ont été proposées pour générer un plasma sous pression réduite.

Selon une solution, on polarise directement les pièces à traiter. Une décharge luminescente est créée dans le proche voisinage de la surface, ce qui excite le mélange de gaz choisi. Cette technique est très utilisée en cémentation ou nitruration ionique, mais induit des hétérogénéités de traitement en fonction de la géométrie et de la disposition des pièces les unes par rapport aux autres. En effet, l'intensification naturelle du plasma, au niveau de zones particulières, telles que trous, arêtes, ..., entraîne une surchauffe locale qui agit de manière défavorable sur la qualité du traitement. Il ressort également de cette technique que les substrats sont soumis à un bombardement ionique intense, ce qui altère leur surface.

Une autre solution ressort de l'enseignement du brevet FR 2.702,119 qui met en oeuvre une antenne destinée à injecter, à la façon d'un four micro-ondes, une onde volumique dans l'enceinte. L'inconvénient principal de cette technologie est que les antennes sont des sources ponctuelles qui peuvent rarement injecter plus de 200 W. Il est donc nécessaire de multiplier le nombre de sources pour avoir un plasma homogène dans une enceinte industrielle. Il en résulte une augmentation de l'encombrement, des coûts ainsi que des risques de défaillance. Ce type d'antenne ne permet d'injecter qu'un signal micro-onde (pas de signaux DC, ni DC-pulsé ni RF) et ne donne son meilleur rendement que dans les conditions physiques particulières de la résonance cyclotronique électronique.

Une autre solution ressort de l'enseignement du brevet FR 2.766.321 qui concerne un dispositif d'excitation d'un gaz comprenant une structure creuse formant un guide d'ondes, la structure étant raccordée à un générateur, tandis que des moyens font circuler le gaz à travers la structure. Un plasma est créé à l'extérieur de la structure ou enceinte, dans un tube creux en matériau diélectrique. Les résultats obtenus ne sont satisfaisants qu'à des pressions relativement élevées pour une technologie sous vide (supérieures à 5 mbar), ce qui induit des problèmes d'écoulement gazeux à l'intérieur de l'enceinte, donc une hétérogénéité de traitement.

Une autre solution ressort de l'enseignement du brevet EP 0 872 569 qui concerne un procédé de nitruration par bombardement ionique, dans lequel un plasma est généré dans un four. Un courant est amené à une cathode en treillis métallique, qui entoure les articles à traiter, l'anode étant constituée par les parois du four. Les cathodes utilisées sont généralement peu efficaces pour créer des espèces actives en grande quantité. Le bombardement ionique auquel sont soumises les cathodes induit leur échauffement qui contribue au chauffage des pièces, ce qui ne permet pas de dissocier la température des pièces de la génération du plasma (donc des espèces actives). Un autre inconvénient rencontré avec ce type de cathode est sa pulvérisation due à de fortes tensions (de l'ordre de 500 volts), ce qui entraîne une pollution des substrats.

Pour remédier à ces inconvénients, afin de limiter la tension sur la cathode, on a proposé de confiner le plasma dans des trous afin de l'intensifier et de faire chuter la tension. Une solution de ce type ressort de l'enseignement du brevet EP 0 881 865, qui concerne un dispositif de production d'une pluralité de jets de plasma basse température au moyen d'une puissance haute fréquence en utilisant des décharges. Le dispositif comprend plusieurs chambres à cathode creuse individuelle, chaque jet de plasma étant associé à une chambre à cathode creuse individuelle, à titre d'enceinte de décharge. Parmi les inconvénients générés avec cette solution, on observe qu'il peut y avoir un déséquilibre de puissance entre les trous, et que la puissance totale est toujours volontairement maintenue à une puissance souvent inférieure à 1 kW, à cause de la surchauffe de l'ensemble résultant d'un bombardement ionique très intense dans les trous.

L'invention s'est fixée pour but de remédier à ces inconvénients d'une manière simple, sûre et efficace.

Le problème que se propose de résoudre l'invention est de générer des plasmas froids de forte puissance, dans une enceinte de pression réduite, en dissociant la température des substrats de la création des espèces actives, afin de réaliser différents types de traitement de surface tel qu'effluvage, traitements thermochimiques, activation, greffage, décapage, ...

Pour résoudre un tel problème, le dispositif met en oeuvre une cathode présentant des chambres creuses pour le confinement électrostatique du plasma. Selon l'invention, le problème posé est résolu par les caractéristiques de la revendication 1,

Pour résoudre le problème posé d'extraire les calories générées par le bombardement ionique intense, au niveau des trous de la cathode, soit l'élément apte à permettre la circulation d'un fluide de refroidissement est indépendant du corps de la cathode, en y étant fixé, d'une manière étanche, soit cet élément et le corps de la cathode constituent un ensemble unitaire.

Le corps de la cathode et l'élément apte à permettre la circulation d'un fluide, sont réalisés dans un matériau amagnétique, conducteur électrique et thermique.

A partir de cette conception de base, soit les aimants ont préférentiellement tous la même orientation Nord-Sud (figure 2), ou ont une répartition alternée (figure 3), ou ont une orientation aléatoire (figure 4).

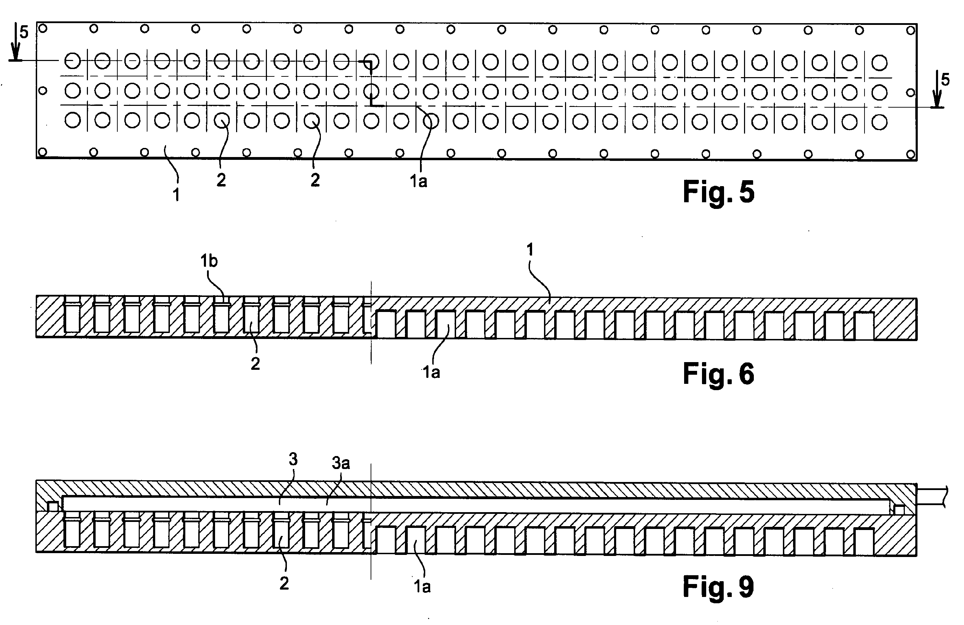

Les configurations magnétiques s'appliquent suivant la largeur ou la longueur de la cathode (figure 5).

Dans une forme de réalisation, le champ magnétique est généré par des aimants cylindriques fixés dans les trous du corps de cathode.

L'invention concerne également l'utilisation du dispositif pour les traitements thermochimiques tels que la nitruration, la cémentation, ...

L'invention est exposée ci-après plus en détail à l'aide des figures des dessins annexés dans lesquels :

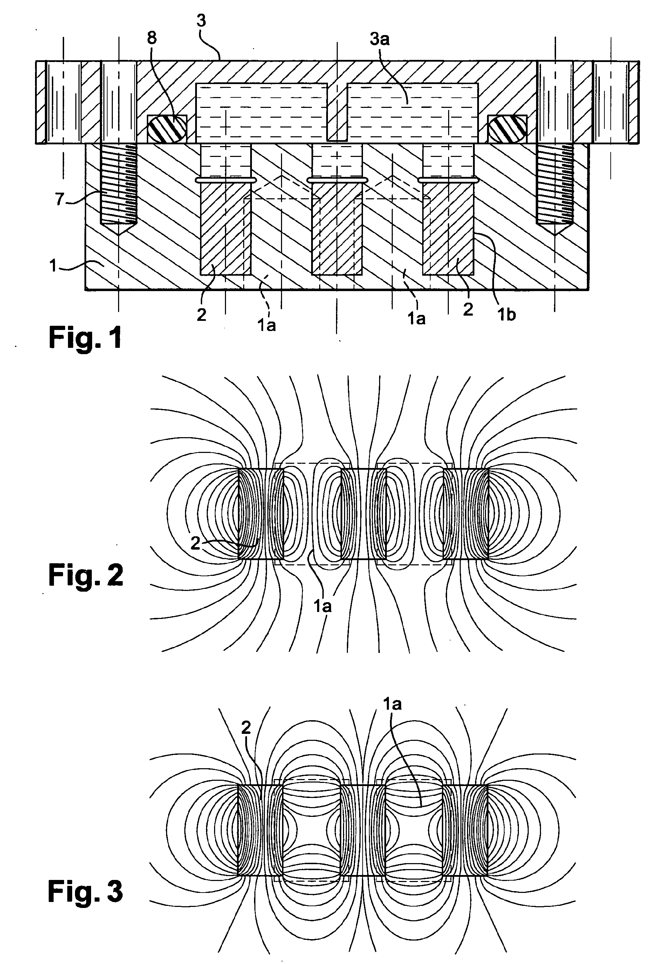

- la figure 1 est une vue en coupe montrant le principe du dispositif selon l'invention
- les figures 2, 3 et 4 sont des vues montrant les lignes de champ en fonction de l'orientation des aimants.
- la figure 5 est une vue de dessous d'un exemple de réalisation de la cathode ;
- la figure 6 est une vue en coupe longitudinale considérée selon la ligne 5-5 de la figure 5 ;

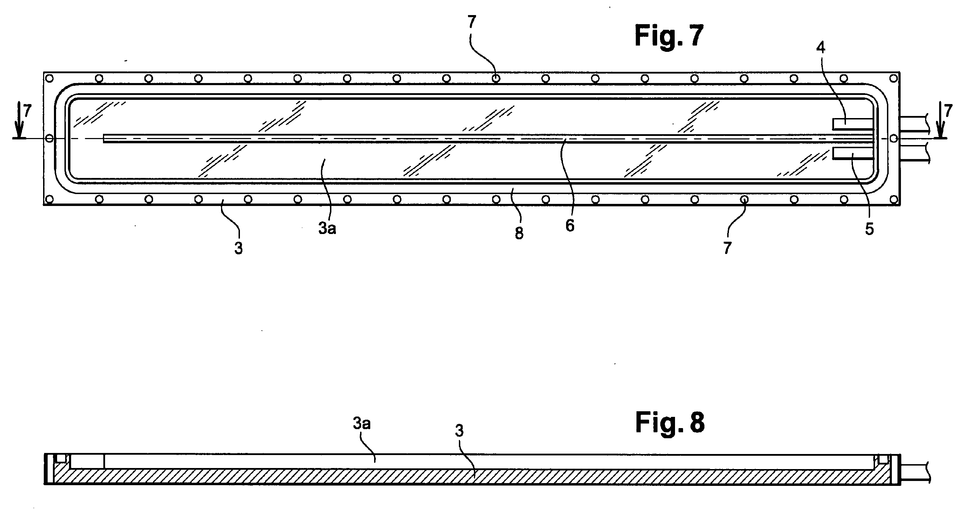

- la figure 7 est une vue en plan du refroidisseur;
- la figure 8 est une vue en coupe longitudinale considérée selon la ligne 7-7 de la figure 7 ;
- la figure 9 est une vue en coupe longitudinale de la cathode équipée du refroidisseur ;

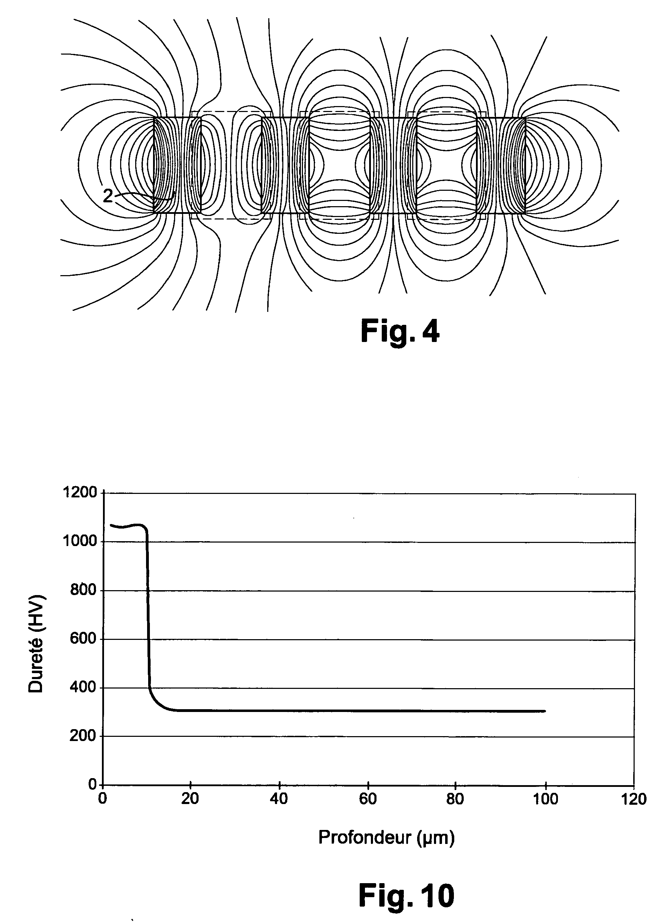

- la figure 10 montre une courbe de dureté en fonction de la profondeur dans le cas d'un acier inoxydable austénitique (304L) nitruré avec le dispositif de l'invention.

Le corps de la cathode, désignée par (1), comprend une pluralité de chambres creuses (1a) pour le confinement du plasma. Le confinement du plasma dans les chambres creuses (1a) permet de l'intensifier et d'augmenter la création d'espèces actives. Chaque chambre creuse (1a) est assujettie à des moyens (2) aptes à créer un champ magnétique obligeant les électrons à tourner autour des lignes de champs. Ces moyens (2) sont constitués par des aimants disposés autour et parallèlement aux chambres creuses sous forme de trous (1a). Ceci a pour effet d'augmenter le nombre de collisions des électrons avec les molécules du gaz environnant, ce qui accroît le taux de production des espèces actives.

Le corps de la cathode (1) coopère avec un refroidisseur (3) pour permettre la circulation d'un fluide de refroidissement pour extraire les calories générées par un bombardement ionique intense au niveau de chacune des chambres creuses (1a). Ce refroidisseur (3) présente un évidement central (3a) qui fait office de bassin en communication avec une arrivée d'eau (4) et une évacuation d'eau (5). On renvoie à la figure 7 qui montre la circulation du fluide de refroidissement, l'eau arrivant en (4) contournant une barrette centrale (6) pour être évacuée en (5). Le refroidisseur (3) est bridé sur le corps de cathode (1) par des vis (7) disposés en périphérie, l'étanchéité étant assurée par un joint torique (8).

Dans cette position de fermeture, les trous (1b) dans lesquels sont disposés les aimants, sont en communication avec le fluide de refroidissement. A noter que les aimants (2) sont du type permanent et constitués par des corps cylindriques fixés dans les trous (1b) du corps (1) de cathode. Les différentes chambres creuses (1a) débouchent du côté du vide de l'enceinte.

Le refroidisseur (3) peut être de dimensions supérieures à celles du corps de la cathode, afin de permettre la fixation de l'ensemble (cathode - refroidisseur) sur un support quelconque grâce au passage de vis.

Le refroidissement de la cathode (1) évite son échauffement, ainsi que celui des substrats qui sont dans l'enceinte. Ces dispositions permettent d'envisager un traitement à basse température où il est nécessaire d'avoir des espèces actives en grande quantité, sans que la cathode contribue de façon notable à la température des pièces. Ce refroidissement garantit également la stabilité magnétique des aimants (2) dont le champ magnétique diminue avec l'augmentation de la température.

Le corps de cathode (1), ainsi que le refroidisseur (3) sont réalisés dans un matériau amagnétique et conducteur, tel que les aciers inoxydables austénitiques, aluminium, chrome, graphite ou encore le titane.

Comme il ressort des figures des dessins, et comme indiqué ci-dessus, le refroidisseur (3) et le corps de cathode (1) constituent deux éléments distincts.

Sans pour cela sortir du cadre de l'invention, on n'exclut pas de réaliser un ensemble monobloc (1-3). Dans ce cas, le corps de la cathode incorpore un circuit d'eau, de façon à la refroidir efficacement. Dans cette forme de réalisation, différentes solutions peuvent être envisagées pour réaliser le circuit d'eau. Par exemple, par forage de canalisations ou par soudure de tubes ou autres sur la surface.

On voit, aux figures 2, 3 et 4, les lignes de champs créées par les aimants (2) qui peuvent être orientés de manière aléatoire, figure 4, ou de façon alternée, figure 3, mais de préférence selon une même orientation Nord-Sud, figure 2. Les lignes de champ résultantes se bouclent dans les chambres creuses (1a) de la cathode et sont parallèles à ces dernières.

Il est possible de choisir des configurations magnétiques différentes pour chaque rangée de 3 aimants (par exemple, une ligne suivant figure 2, puis une ligne suivant figure 3, etc...).

A noter que la fixation des aimants (2) dans les trous (1b) du corps de cathode, est effectuée par tout moyen connu tel que circlips. Eventuellement les aimants peuvent être sertis dans leur logement. Comme la cathode est refroidie, les aimants (2) peuvent être constitué d'un matériau à basse température de curie comme les néodyme-fer-bore, ou les ferrites, mais également des aimants à température de curie élevée comme les AlNiCo ou encore les samarium-cobalt.

La cathode peut être alimentée soit par un courant continu (DC), soit par un courant continu-pulsé (DC-Pulsé), soit par un courant basse fréquence, soit par un courant radiofréquence (RF). A puissance égale, le courant radiofréquence présente l'avantage de limiter la pulvérisation de la cathode et de fournir une décharge plus stable que dans les autres modes d'alimentation. Le tableau 1 résume les tensions observées (à 600°C en ambiante) sur la cathode pour une pression de 10⁻¹ mbar et pour un mélange argon, azote et hydrogène.

**Tableau 1 : Tensions mesurées sur la cathode en fonction du mode d'excitation.**

| Type d'alimentation | Tension mesurée sur la cathode en volts (Puissance incidente : 2 kW) |
|---|---|
| DC | 550 |
| DC-Pulsé à 250 KHz | 450 |
| RF à 13,56 MHz | 155 |

Pour une pression de l'ordre de 10⁻¹ mbar, sous 200 V, la pulvérisation des trous de la cathode devient très faible, ce qui lui confère une durée de vie importante : après plus de 500 heures de fonctionnement (à 4,5 W/cm²), l'usure mesurée dans les trous (1a) de la cathode (1) s'est révélée faible (inférieure à 1 mm au rayon) et très homogène.

Des essais effectués à titre confidentiel ont permis de mettre en évidence des avantages importants obtenus par les caractéristiques de la cathode selon l'invention, résultant essentiellement de la combinaison des chambres creuses, des aimants et de leur refroidissement.

La puissance appliquée sur la cathode peut être de plusieurs kW. Avec une cathode non refroidie, les traitements à basse température doivent obligatoirement s'accompagner d'une diminution de la puissance (donc diminution de la densité d'espèces actives) afin de limiter le chauffage de la cathode par le bombardement ionique. Avec une cathode creuse magnétique refroidie selon l'invention, même après 5 heures de fonctionnement à 2 kW (soit 6 W/ cm² si l'on considère que l'essentiel de la puissance est localisée dans les trous), la température dans l'enceinte ne dépasse pas les 150°C, ce qui est impossible avec les autres types de cathodes tels que définis selon l'état de la technique.

Contrairement aux courants DC et DC-pulsé, le courant radiofréquence (RF) a l'avantage de délivrer une décharge stable quelle que soit la température. Le tableau 2 donne des exemples de tensions observées en fonction de la température ainsi que la pression limite en dessous de laquelle le plasma s'éteint dans les trous.

**TABLEAU 2**

| Type d'alimentation | Tension mesurée à 20° (V) | Tension mesurée à 500°C (V) | Pression d'extinction du plasma à 20°C (mbar) | Pression d'extinction du plasma à 500°C (mbar) |
|---|---|---|---|---|
| DC | 350 | 500 | 0,120 | 0,250 |
| DC-pulsé | 250 | 430 | 0,090 | 0,180 |
| RF (13,56 MHz) | 150 | 155 | 0,001 | 0,001 |

La dérive de la tension en fonction de la température pour les décharges DC et DC-pulsé est un phénomène très inattendu, d'autant plus que la dérive n'existe pas avec les décharges RF.

En théorie, la configuration du champ magnétique telle que présentée figure 2 ne permet pas aux électrons de passer d'un trou à l'autre. Pourtant, dès que le plasma s'allume dans un trou, il s'allume aussitôt dans tous les autres alors que cela ne se produit pas en absence d'aimants.

La dimension optimale des trous dépend de la pression de travail : plus elle et faible et plus le diamètre des trous doit être important. Le domaine d'utilisation des cathodes creuses magnétiques refroidies s'étend entre 10⁻⁵ et 30 mbar. Les diamètres des trous correspondants varient entre 100 et 0,1 mm. Dans tous les cas, il est préférable que la profondeur des trous soit au moins égale à leur diamètre pour optimiser le rendement de la décharge.

Des essais de nitruration ont été réalisés avec une cathode creuse magnétique refroidie conforme à l'invention, composée de 32 trous de diamètre 16 mm et 51 aimants de diamètre 10 mm. Les dimensions de la cathode utilisée sont : 400 x 80 x 50 mm.

Dans un mélange argon (50 %), azote (30 %) et hydrogène (20 %), se forme une couche de combinaison de 10 µm sur un 42CrMo4 en 4 heures à 580°C, pour une pression de 10⁻¹ mbar et une puissance de 1500 W RF sur la cathode. Dans les mêmes conditions, l'utilisation d'une cathode classique (sans trous ni aimants) ne permet de former qu'une couche de 2 à 3 µm.

Avec un mélange pauvre en azote (10 % dilués dans 90 % d'hydrogène), il est possible d'éviter la formation d'une couche de combinaison et ce, quelle que soit la température, pour les applications où cette couche n'est pas souhaitée : travail aux chocs, dépôts PVD après nitruration, ...

Il a également été possible de nitrurer des aciers inoxydables à des températures aussi basses que 400°C (donc sans perte des propriétés anticorrosion) tout en conservant des puissances élevées sur la cathode (> 2 kW). Un durcissement sur 10 µm a été mesuré sur un acier inoxydable austénitique (304L) après 24 heures de traitement à 400°C (voir figure 10).

A noter que, pour augmenter les dimensions de la cathode, il suffit d'accroître sa longueur en répétant le motif de base (un trou entouré de quatre aimants, par exemple), ou encore d'augmenter sa largeur en rajoutant de nouvelles rangées de trous et d'aimants. La forme de la cathode peut être adaptée à tout type d'enceinte : elle peut être ronde, carrée ou rectangulaire.

Les avantages ressortent bien de la description.

## Revendications

1. Dispositif pour générer un plasma froid dans une enceinte sous vide au moyen d'une cathode (1) présentant des chambres creuses (1a) pour le confinement du plasma,
**caractérisé en ce qu'**il comprend des aimants (2) disposés parallèlement aux chambres creuses (1a) dans des trous (1b), les chambres creuses (1a) débouchant du côté vide dans l'enceinte pour obliger les - électrons à tourner autour des lignes des champs, le corps de la cathode (1) coopérant avec un élément (3) apte à permettre la circulation d'un fluide de refroidissement pour extraire les calories générées par un bombardement ionique intense au niveau de chacune desdites chambres creuses (1a).

2. Dispositif selon la revendication 1, **caractérisé en ce que** les trous (1b) sont en communication avec le fluide de refroidissement.

3. Dispositif selon la revendication 1, **caractérisé en ce que** l'élément (3) apte à permettre la circulation d'un fluide de refroidissement est indépendant du corps de la cathode (1), en y étant fixé, d'une manière étanche.

4. Dispositif selon la revendication 1, **caractérisé en ce que** l'élément (3) apte à permettre la circulation d'un fluide de refroidissement et le corps de la cathode (1), constituent un ensemble unitaire.

5. Dispositif selon la revendication 1, **caractérisé en ce que** le corps de la cathode (1) et l'élément (3) apte à permettre la circulation d'un fluide, sont réalisés dans un matériau amagnétique et conducteur.

6. Dispositif selon la revendication 1, **caractérisé en ce que** les aimants (2) ont tous la même orientation Nord-Sud.

7. Dispositif selon la revendication 1, **caractérisé en ce que** les aimants (2) sont orientés d'une manière aléatoire.

8. Dispositif selon la revendication 1, **caractérisé en ce que** les aimants (2) ont une orientation alternée.

9. Dispositif selon la revendication, **caractérisé en ce que** les aimants (2) sont du type permanent et constitués par un corps cylindrique fixé dans les trous (1b) du corps de cathode (1).

10. Utilisation du dispositif selon l'une quelconque des revendications 1 à 9 pour des traitements thermochimiques.

11. Utilisation du dispositif selon l'une quelconque des revendications 1 à 9 pour la nitruration.

## Claims

1. Device for generating a cold plasma in a vacuum vessel by means of a cathode (1) having hollow chambers (1a) for containment of the plasma,
**characterised in that** it includes magnets (2) placed parallel to the hollow chambers (1a) in holes (1b), the hollow chambers (1a) emerging on the vacuum side in the enclosure, to force the electrons to rotate around the field lines, the body of the cathode (1) engaging with an element (3) capable of allowing a cooling fluid to circulate in order to extract the calories generated by an intense ion bombardment on each of the hollow chambers (1a).

2. Device as claimed in claim 1, **characterised in that** the holes (1b) are in communication with the cooling fluid.

3. Device as claimed in claim 1, **characterised in that** the element (3) capable of allowing a cooling fluid to circulate is independent of the body of the cathode (1), while being secured thereto in a sealed manner.

4. Device as claimed in claim 1, **characterised in that** the element (3) capable of allowing a cooling fluid to circulate and the body of the cathode (1) constitute a single unit.

5. Device as claimed in claim 1, **characterised in that** the body of the cathode (1) and the element (3) capable of allowing a fluid to circulate are made out of a nonmagnetic conductive material.

6. Device as claimed in claim 1, **characterised in that** the magnets (2) all have the same North-South orientation.

7. Device as claimed in claim 1, **characterised in that** the magnets (2) are randomly oriented.

8. Device as claimed in claim 1, **characterised in that** the magnets (2) have an alternating orientation.

9. Device as claimed in claim 1, **characterised in that** the magnets (2) are of the permanent type constituted by a cylindrical body secured in the holes (1b) of the body of the cathode (1).

10. Use of the device as claimed in any one of claims 1 to 9 for thermochemical treatments.

11. Use of the device as claimed in any one of claims 1 to 9 for nitridation.

## Patentansprüche

1. Vorrichtung zur Generierung eines kalten Plasmas in einem Vakuummantel mittels einer Kathode (1) mit Hohlkammern (1a) für den Einschluss des Plasmas,
**dadurch gekennzeichnet, dass** sie Magneten (2) umfasst, die parallel zu den Hohlkammern (1a) in Löchern (1b) angeordnet sind, wobei die Hohlkammern (1a) auf der Vakuumseite in den Mantel münden, um die Elektroden zu zwingen, die Feldlinien zu umkreisen, wobei der Körper der Kathode (1) mit einem Element (3) zusammenwirkt, das geeignet ist, den Umlauf eines Kühlmediums zu ermöglichen, um die Wärme aufzunehmen, die durch einen intensiven Ionenbeschuss im Bereich jeder Hohlkammer (1a) erzeugt wird.

2. Vorrichtung nach Anspruch 1, **dadurch gekennzeichnet, dass** die Löcher (1b) mit dem Kühlmedium in Verbindung stehen.

3. Vorrichtung nach Anspruch 1, **dadurch gekennzeichnet, dass** das für den Umlauf eines Kühlmediums geeignete Element (3) vom Körper der Kathode (1) unabhängig und auf dichte Weise daran befestigt ist.

4. Vorrichtung nach Anspruch 1, **dadurch gekennzeichnet, dass** das für den Umlauf eines Kühlmediums geeignete Element (3) und der Körper der Kathode (1) eine einheitliche Baugruppe bilden.

5. Vorrichtung nach Anspruch 1, **dadurch gekennzeichnet, dass** der Körper der Kathode (1) und das für den Umlauf eines Mediums geeignete Element (3) aus einem amagnetischen und leitfähigen Material bestehen.

6. Vorrichtung nach Anspruch 1, **dadurch gekennzeichnet, dass** die Magnete (2) alle die gleiche Nord-Süd-Ausrichtung haben.

7. Vorrichtung nach Anspruch 1, **dadurch gekennzeichnet, dass** die Magnete (2) in zufälliger Weise ausgerichtet sind.

8. Vorrichtung nach Anspruch 1, **dadurch gekennzeichnet, dass** die Magnete (2) alternierend ausgerichtet sind.

9. Vorrichtung nach Anspruch 1, **dadurch gekennzeichnet, dass** die Magnete (2) Permanentmagnete sind und aus einem zylindrischen Körper bestehen, der in den Löchern (1b) des Kathodenkörpers (1) befestigt ist.

10. Verwendung der Vorrichtung nach einem der Ansprüche 1 - 9 für thermochemische Behandlungen.

11. Verwendung der Vorrichtung nach einem der Ansprüche 1 - 9 zum Nitrieren.
